# EUROPEAN PATENT APPLICATION

(11) **EP 2 546 986 A2**
(43) Date of publication of application: **16.01.2013**
(21) Application number: 12175466.7
(22) Date of filing: 06.07.2012
(51) Int. Cl.: H03K 17/30, H03K 17/567

(54) **Nested Composite Diode**

(30) Priority: 11.07.2011 US 201161506529 P; 05.07.2012 US 201213542453
(71) Applicant: International Rectifier Corporation, El Segundo, CA 90245 (US)
(72) Inventor: Briere, Michael A., Scottsdale, AZ 85266 (US)
(74) Representative: Dr. Weitzel & Partner

(57) **Abstract**

There are disclosed herein various implementations of nested composite diodes.

In one implementation, a nested composite diode includes a primary transistor coupled to a composite diode. The composite diode includes a low voltage (LV) diode cascoded with an intermediate transistor having a breakdown voltage greater than the LV diode and less than the primary transistor. In one implementation, the primary transistor may be a group III-V transistor and the LV diode may be an LV group IV diode.

## Description

### BACKGROUND

The present application claims the benefit of and priority to a pending provisional application entitled 'Nested Composite Cascoded Device," Serial No. 61/506,529 filed on July 11, 2011. The disclosure in this pending provisional application is hereby incorporated fully by reference into the present application.

### I. DEFINITIONS

As used herein, the phrase "group III-V" refers to a compound semiconductor that includes a group V element and at least one group III element. Moreover, the phrase "III-Nitride or III-N" refers to a compound semiconductor that includes nitrogen (N) and at least one group III element including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. III-Nitride also refers generally to any polarity including but not limited to Ga-polar, N-polar, semi-polar or non-polar crystal orientations. A III-Nitride material may also include either the Wurtzitic, Zincblende or mixed polytypes, and may include single-crystal, monocrystalline, polycrystalline, or amorphous structures.

Also as used herein, the phrase "group IV" refers to a semiconductor that includes at least one group four element including silicon (Si), germanium (Ge), and carbon (C), and also includes compound semiconductors such as SiGe and SiC, for example. Group IV may also refer to a semiconductor material which consists of layers of group IV elements or doping of group IV elements to produce strained silicon or other strained group IV material. In addition, group IV based composite substrates may include silicon on insulstor (SOI), separation by implantation of oxygen (SIMOX) process substrates, and silicon on sapphire (SOS), for example. Moreover, a group IV device may include devices formed using standard CMOS processing, but may also include NMOS and PMOS device processing.

Furthermore, as used herein, the terms "LV device," "low voltage semiconductor device," "low voltage diode," and the like, refer to a low voltage device with a typical breakdown voltage rating less than an "intermediate device," as described below. The LV device can include any suitable semiconductor material that forms a diode. Suitable semiconductor materials include group IV semiconductor materials such as Si, strained silicon, SiGe, SiC, and group III-V materials including III-As, III-P, III-Nitride or any of their alloys.

Additionally, the term "intermediate device," "intermediate transistor," and "intermediate switch" refers to a device with a typical breakdown voltage greater than the LV device and less than a "primary device." The "primary device," "primary transistor," or "primary switch" refers to a device with a typical breakdown voltage greater than both the intermediate device and the LV device.

### II. BACKGROUND ART

In high power and high performance switching applications, group III-V field-effect transistors (FETs) and high mobility electron transistors (HEMTs), such as III-Nitride FETs and III-Nitride HEMTs, are often desirable for their high efficiency and high-voltage operation. Moreover, it is often desirable to combine such group III-V transistors with other semiconductor devices, such as group IV diodes, to create high performance composite diodes.

In power management applications where relatively high voltage characteristics are desirable, a depletion mode (normally ON) III-Nitride or other group III-V transistor can be cascoded with a low-voltage (LV) group IV diode, for example a silicon diode, to produce a relatively high voltage composite diode. However, the performance of the composite diode can be limited by the on-state and voltage breakdown characteristics of the LV group IV diode used. In particular, the breakdown voltage for a given on-state resistance of the LV group IV diode may be insufficient to support the required pinch-off voltage required to maintain the group III-V transistor in a satisfactorily OFF condition.

### SUMMARY

The present disclosure is directed to a nested composite diode, substantially as shown in and/or described in connection with at least one of the figures, and as set forth more completely in the claims.

### BRIEF DESCRIPTION OF THE DRAWINGS

Figure 1 presents a diagram showing one exemplary implementation of a nested composite diode including a primary transistor and a composite diode.
Figure 2 presents a diagram showing a more detailed exemplary implementation of a composite diode suitable for use in a nested composite diode.
Figure 3 presents a diagram showing an exemplary implementation of a nested composite diode including a primary transistor, and a composite diode corresponding generally to the implementation shown in Figure 2.
Figure 4 presents a diagram showing an exemplary implementation of a multi-nested composite diode.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

Group III-V semiconductors include III-Nitride materials formed of gallium nitride (GaN) and/or its alloys, such as aluminum gallium nitride (AlGaN), indium gallium nitride (InGaN), and aluminum indium gallium nitride (AlInGaN). These materials are semiconductor compounds that have a relatively wide, direct bandgap and strong piezoelectric polarizations, and can support high breakdown fields, high saturation velocities, and the creation of two-dimensional electron gases (2DEGs). As a result, III-Nitride materials such as GaN are used in many microelectronic applications such as depletion mode (e.g., normally ON) power field-effect transistors (FETs) and high electron mobility transistors (HEMTs).

As noted above, in power management applications where relatively high voltage characteristics are desirable, a normally ON III-Nitride or other group III-V transistor can be cascoded with a low voltage (LV) diode to produce a relatively high voltage composite diode. However, the performance of the composite diode can be limited by the on-state and voltage breakdown characteristics of the LV diode used. In particular, the breakdown voltage for a given on-state resistance of the LV group IV diode may be insufficient to support the required pinch-off voltage required to maintain the group III-V primary transistor in a satisfactorily OFF condition. In such a case, an intermediate III-V transistor may be used in a nested cascode configuration.

The present application is directed to a nested composite diode capable of providing enhanced voltage breakdown resistance while providing advantages, such as fast switching speed, typically associated with an LV device. According to one implementation, the nested composite diode includes a primary transistor coupled to a composite diode. The composite diode may including an LV diode cascoded with an intermediate transistor (for example a depletion mode or normally ON III-N transistor) having a breakdown voltage greater than that that of the LV diode and less than that of the primary transistor. Moreover, in one implementation, the composite diode including the LV diode, can be cascoded with the primary transistor. The cascoded combination of the composite diode with the primary transistor, which may be a normally ON III-Nitride or other group III-V device, for example, can be implemented to produce a nested composite diode having an increased speed and breakdown voltage.

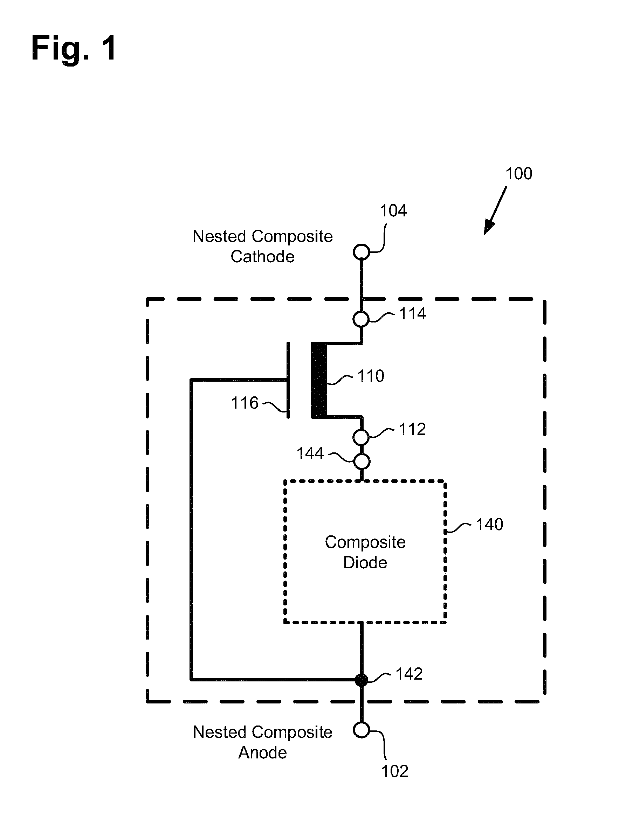

Figure 1 shows one exemplary implementation of a nested composite diode including a primary transistor and a composite diode. As shown in Figure 1, nested composite diode 100 includes primary transistor 110 and composite diode 140 coupled to primary transistor 110. As further shown in Figure 1, nested composite diode 100 has nested composite anode 102 and nested composite cathode 104. Also shown in Figure 1 are source 112, drain 114, and gate 116 of primary transistor 110, and composite anode 142 and composite cathode 144 of composite diode 140.

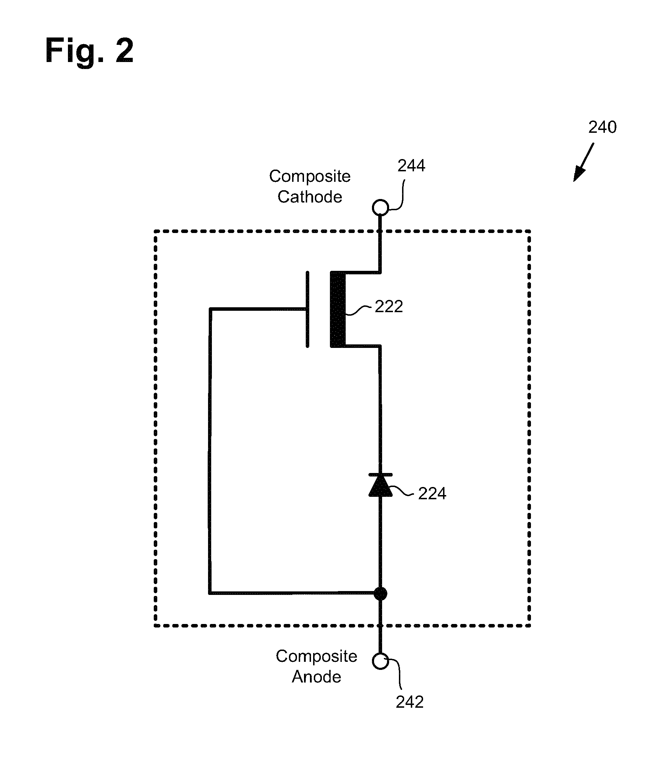

Referring now to Figure 2, Figure 2 shows a more detailed exemplary implementation of a composite diode suitable for use in a nested composite diode. As shown in Figure 2, composite diode 240 includes intermediate transistor 222 and LV diode 224 cascoded with intermediate transistor 222. Also shown in Figure 2 are composite anode 242 and composite cathode 244 of composite diode 240. Composite diode 240 having composite anode 242 and composite cathode 244 corresponds to composite diode 140 having composite anode 142 and composite cathode 144, in Figure 1. LV diode 224 may be implemented as an LV group IV diode, such as a silicon diode having a breakdown voltage of approximately 10V or less, such as 3V, for example.

Intermediate transistor 222 may be formed of III-N, and may be implemented as a HEMT or heterostructure FET (HFET), for example. According to one implementation, intermediate transistor 222 has a breakdown voltage greater than that of LV diode 224 and less than that of primary transistor 110, in Figure 1. More specifically, the breakdown voltage of intermediate transistor 222 is typically greater than the largest pinch-off voltage required to turn primary transistor 110 OFF.

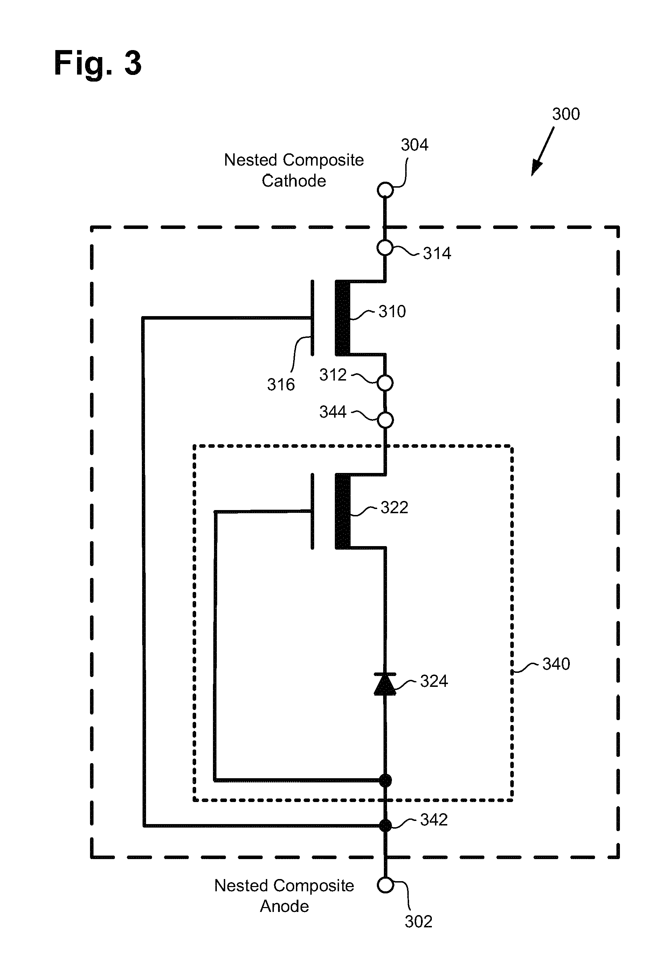

Figure 3 shows an exemplary implementation of a nested composite diode including a primary transistor, and a composite diode corresponding generally to the implementation shown in Figure 2. Nested composite diode 300 includes primary transistor 310 coupled to composite diode 340. As shown in Figure 3, composite diode 340 includes LV diode 324 cascoded with intermediate transistor 322. Also shown in Figure 3 are nested composite anode 302 and nested composite cathode 304 of nested composite diode 300, as well as source 312, drain 314, and gate 316 of primary transistor 310, and composite anode 342 and composite cathode 344 of composite diode 340.

Nested composite diode 300 having nested composite anode 302 and nested composite cathode 304 corresponds to nested composite diode 100 having nested composite anode 102 and nested composite cathode 104, in Figure 1, and may share any of the characteristics previously attributed to those corresponding features, above. In addition, composite diode 340 having composite anode 342 and composite cathode 344 corresponds to composite diode 240 having composite anode 242 and composite cathode 244, in Figure 2, and may share any of the characteristics previously attributed to those corresponding features.

Primary transistor 310 and composite diode 340 are coupled using a cascode configuration to produce nested composite diode 300, which according to the implementation shown in Figure 3 results in a composite two terminal device. As a result, nested composite diode 300 can function in effect as a diode having nested composite anode 302 provided by composite diode 340, and nested composite cathode 304 provided by primary transistor 310. In other words, composite cathode 344 of composite diode 340 is coupled to source 312 of primary transistor 310, and composite anode 342 of composite diode 340 provides nested composite anode 302 for nested composite diode 300. Moreover, drain 314 of primary transistor 310 provides nested composite cathode 304 for nested composite diode 300, while gate 316 of primary transistor 310 is coupled to composite anode 342 of composite diode 340.

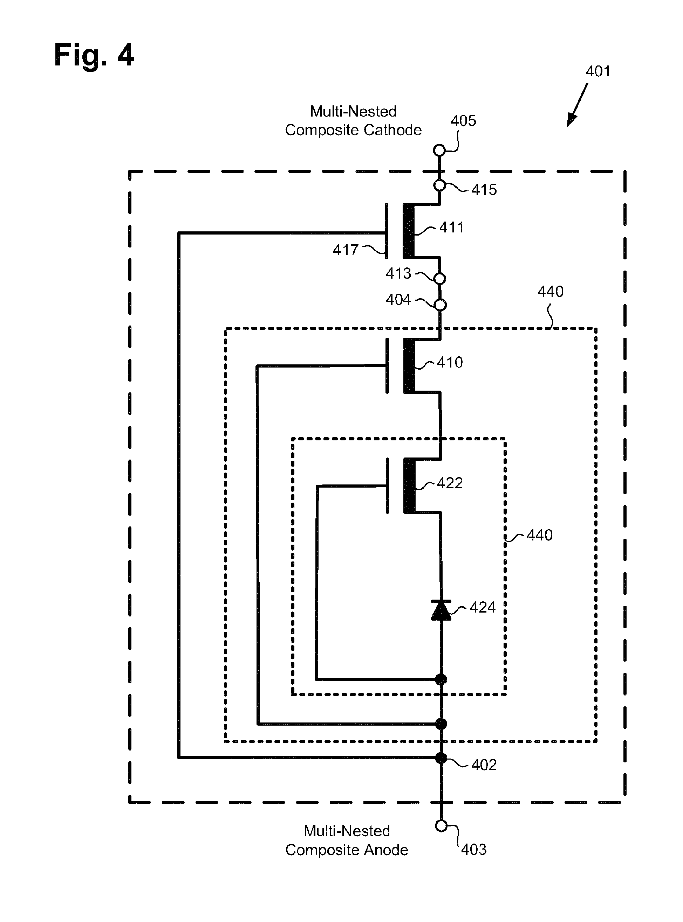

The implementation shown in Figure 3 advantageously provides nested composite diode 300 having increased switching speed when compared to conventional high voltage diodes with comparable standoff capability. In some implementations, it may be advantageous to nest another high voltage or primary transistor with the nested composite diode shown in Figure 3. An exemplary implementation of such a multi-nested composite diode is shown in Figure 4.

Multi-nested composite diode 401 includes higher voltage (HV+) primary transistor 411 coupled to nested composite diode 400. Nested composite diode 400 includes primary transistor 410 coupled to composite diode 440, and corresponds to nested composite diode 300 including primary transistor 310 coupled to composite diode 340, in Figure 3. As used herein, "HV+ primary transistor" refers to a primary transistor having a breakdown voltage equal to or greater than the breakdown voltage of primary transistor 410.

According to the implementation shown in Figure 4, HV+ primary transistor 411 and nested composite diode 400 are coupled using a cascode configuration to produce multi-nested composite diode 401. That is to say, nested composite cathode 404 of nested composite diode 400 is coupled to source 413 of HV+ primary transistor 411, and nested composite anode 402 of nested composite diode 400 provides multi-nested composite anode 403 for multi-nested composite diode 401. Moreover, drain 415 of HV+ primary transistor 411 provides multi-nested composite cathode 405 for multi-nested composite diode 401, while gate 417 of HV+ primary transistor 411 is coupled to nested composite anode 402 of nested composite diode 400.

The implementation shown in Figure 4 advantageously provides fast switching speed analogous to the implementation in Figure 3, while producing a higher breakdown voltage. In yet other implementations, it may be desirable to repeat this nesting of cascoded composite diodes including one LV group IV diode and several normally ON group III-V transistors to produce a multi-nested composite diode capable of very high voltage operation.

In some implementations, it may further be desirable to reduce package parasitics, such as package inductances of the nested or multi-nested composite diode. Referring back to Figure 3, for example, one possible solution for reducing package parasitics for nested composite diode 300 is through monolithic integration of primary transistor 310 and/or composite diode 340. In other words, two or more of primary transistor 310, intermediate transistor 322, and LV diode 324 may be monolithically integrated on a common composite semiconductor substrate designed to support both group IV and group III-V device fabrication.

Thus, by coupling a primary transistor to a composite diode including an LV diode cascoded with an intermediate transistor, the present application discloses a nested composite diode having increased breakdown voltage. Moreover, when implemented so as to use the LV diode to control current through the primary transistor, the implementations disclosed herein provide a nested composite diode having increased speed when compared to conventional high voltage devices. The addition of an intermediate switch allows the use of a low voltage diode which would not otherwise be capable of adequately maintaining the primary switch in an OFF state within a cascode configuration.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A nested composite diode comprising:
a normally ON primary transistor coupled to a composite diode;
said composite diode including a low voltage (LV) diode cascoded with an intermediate transistor having a breakdown voltage greater than said LV diode and less than said primary transistor.

2. The nested composite diode of claim 1, wherein said normally ON primary transistor is a group III-V transistor.

3. The nested composite diode of claim 1, wherein said normally ON primary transistor is one of a III-Nitride heterostructure field-effect transistor (HFET) and a III-Nitride high electron mobility transistor (HEMT).

4. The nested composite diode of claim 1, wherein said LV diode is an LV group IV diode.

5. The nested composite diode of claim 1, wherein said LV diode is an LV silicon diode.

6. The nested composite diode of claim 1, wherein said nested composite diode is monolithically integrated.

7. The nested composite diode of claim 1, wherein at least two of said normally ON primary transistor, said intermediate transistor, and said LV diode are monolithically integrated.

8. The nested composite diode of claim 1, wherein:
a composite cathode of said composite diode is coupled to a source of said normally ON primary transistor, a composite anode of said composite diode provides a nested composite anode for said nested composite diode;
a drain of said normally ON primary transistor provides a nested composite cathode for said nested composite diode, and a gate of said normally ON primary transistor is coupled to said composite anode of said composite diode.

9. The nested composite diode of claim 1, wherein said nested composite diode is cascoded with one or more higher voltage (HV+) primary transistors.

10. A nested composite diode comprising:
a normally ON primary group III-V transistor coupled to a composite diode;
said composite diode including a low voltage (LV) diode cascoded with an intermediate transistor having a breakdown voltage greater than said LV diode and less than said normally ON primary group III-V transistor.

11. The nested composite diode of claim 10, wherein said normally ON primary group III-V transistor is a normally ON III-Nitride transistor.

12. The nested composite diode of claim 10, wherein said normally ON primary group III-V transistor is one of a III-Nitride heterostructure field-effect transistor (HFET) and a III-Nitride high electron mobility transistor (HEMT).

13. The nested composite switch of claim 10, wherein said nested composite diode is monolithically integrated.

14. The nested composite diode of claim 10, wherein said nested composite diode is cascoded with one or more higher voltage (HV+) primary transistors.

15. A nested composite diode comprising:
a primary group III-V transistor coupled to a composite diode;
said composite diode including a low voltage (LV) group IV diode cascoded with an intermediate group III-V transistor having a breakdown voltage greater than said LV group IV diode and less than said primary group III-V transistor.
